Europäisches Patentamt

European Patent Office

Office européen des brevets

(19)

(11) Numéro de publication: **0 501 095 A1**

# DEMANDE DE BREVET EUROPEEN

(21) Numéro de dépôt: **91870220.0**

(22) Date de dépôt: **27.12.91**

(51) Int. Cl.5: **C23C 18/18**, C23C 18/16

(30) Priorité: **01.03.91 BE 9100198**

(43) Date de publication de la demande:
**02.09.92 Bulletin 92/36**

(84) Etats contractants désignés:
**AT BE CH DE ES FR GB IT LI NL SE**

(71) Demandeur: **Laude, Lucien Diégo**
**64, Rue des Lilas**
**F-59330 Hautmont(FR)**

(72) Inventeur: **Laude, Lucien Diégo**
**64, Rue des Lilas**
**F-59330 Hautmont(FR)**

(74) Mandataire: **Schmitz, Yvon et al**
**Bureau Gevers S.A. rue de Livourne 7 bte 1**
**B-1050 Bruxelles(BE)**

(54) **Procédé de métallisation de surfaces diélectriques contenant un métal.**

(57) La métallisation produite par l'application du procédé décrit dans l'invention est opérée en 2 étapes successives. La première consiste à irradier la surface du matériau diélectrique par un faisceau laser préalablement mis en forme (longueur d'onde, énergie, densité d'énergie, temps d'irradiation). La seconde étape consiste à plonger la pièce en matériau diélectrique et irradiée préalablement dans un bain autocatalytique contenant le métal que l'on souhaite déposer. Ce dépôt se forme uniquement dans les zones irradiées et suit exactement le profil géométrique de ces zones. Le reste de la surface, qui n'a pas été irradiée, ne se recouvre pas de métal pendant l'immersion dans le bain. Les caractéristiques du dépôt métallique (épaisseurs, structure), sont entièrement contrôlées par les caractéristiques de l'irradiation et celles du matériau diélectrique.

EP 0 501 095 A1

L'invention concerne un procédé de métallisation de la surface de pièces fabriquées avec des matériaux diélectriques. Ces matériaux sont, par exemple, des céramiques comme l'alumine, ($Al_2O_3$), les oxydes de beryllium et de zirconium (BeO et ZrO), des ferrites, des céramiques supraconductrices, le sapphire, les nitrures de métal (AlN, par exemple).

Les difficultés rencontrées couramment pour la métallisation de tels matériaux résultent de leurs propriétés physico-chimiques qui sont très différentes de celles des métaux. Ils sont, en particulier, passifs vis-à-vis des agents chimiques, isolants électriques, très résistants à l'usure mécanique par frottement.

Tout film métallique déposé par évaporation ou pulvérisation sous vide sur la surface de tels matériaux est habituellement très peu adhérent, ce qui peut être corrigé, en principe, par un traitement thermique de la pièce ainsi métallisée sur sa surface. Ce traitement provoque uniquement la diffusion simple des atomes métalliques vers l'intérieur de la pièce sur une profondeur limitée par la structure du matériau constituant la pièce. Cette diffusion ne s'accompagne jamais d'une modification de la chimie de l'ensemble formé par le matériau diélectrique et le film métallique condensé sur sa surface ; par exemple, aucune liaison chimique forte n'est formée entre un atome métallique diffusant et un des éléments atomiques du matériau de la pièce.

Comme les coefficients de dilatation thermique de la pièce support et du film sont, en général, très différents, des contraintes thermiques importantes apparaissent à l'interface film/support ce qui produit le détachement du film, notamment pour des épaisseurs supérieures à 1 $\mu$m.

On peut encore choisir de disposer à la surface de la pièce une couche très épaisse (0.5 mm) d'une pâte contenant des atomes métalliques distribués en forte concentration dans une résine. En portant dans un four la pièce ainsi recouverte, la résine se dégrade et simultanément les atomes métalliques diffusent vers l'intérieur de la pièce comme précédemment. Si le traitement est maintenu pendant plusieurs heures à haute température (600° C ou plus), la diffusion est suffisamment profonde pour accroître de façon substantielle l'adhérence du film. Cependant, cette méthode ne permet pas de fabriquer des films dont la géométrie est complexe et relativement précise (50 $\mu$m ou moins). Elle ne peut s'appliquer qu'à des films disposes sur une surface plane ou cylindrique. Surtout, cette méthode ne peut s'appliquer à des matériaux possédant une composition complexe dont la stoechiométrie est très précise, comme les composites, ferrites ou supraconducteurs. En particulier, cette méthode ne peut être utilisée lorsque la pièce à métalliser superficiellement contient, soit dans son volume, soit à sa surface, des systèmes électroniques ou optoélectroniques sensibles à la température.

Une technique plus récente utilise la décomposition d'une substance organo-métallique préalablement condensée sur la surface de la pièce. En général, cette condensation s'opère par séchage rapide d'une solution contenant la substance organo-métallique et préalablement distribuée sur la surface par pulvérisation à l'air libre. Le solvant s'évapore et la substance reste condensée sous forme d'un film mince (épaisseur < 0.1$\mu$m) solide sur la surface. L'irradiation du film par un faisceau laser possédant des caractéristiques définies (énergie, puissance, densité d'énergie, longueur d'onde) permet de décomposer la substance qui libère d'une part, une partie volatile qui est éliminée de la surface et d'autre part, des atomes métalliques qui restent sur la surface. Ceux-ci sont distribués de façon discontinue et aléatoire sur cette surface, sans former de film métallique homogène et continu. Après irradiation, la pièce est immergée dans un solvant spécifique de la substance organo-métallique pour éliminer de la surface la substance non-irradiée.

Cette pièce est ensuite immergée dans un bain autocatalytique contenant des ions métalliques. Ceux-ci se fixent préférentiellement sur les atomes métalliques libérés dans l'étape précédente à la suite de l'irradiation et déjà présents à la surface de la pièce. Un film métallique contenant ces ions est alors formé de façon continue sur la surface.

Ce dernier procédé utilisant une substance organo-métallique possède donc 6 étapes successives :

1 fabrication de la solution contenant la substance organo-métallique;

2 distribution de cette solution sur la surface;

3 séchage de cette solution et formation de la couche organo-métallique;

4 irradiation par un faisceau laser;

5 dissolution des parties de la couche organo-métallique non-irradiée;

6 immersion dans un bain auto-catalytique.

La présente invention a pour but de remédier aux inconvénients présentés par les techniques actuelles de fabrication d'un film métallique très adhérent sur une surface diélectrique. En particulier, cette invention résuit le temps de traitement de la surface, simplifie la procédure de traitement, élimine la nécessité d'utiliser la substance organo-métallique, et, par conséquent, est beauxoup moins onéreuse que ces techniques. Simultanément, l'interface entre le film métallique et la pièce en matériau diélectrique, telle que produite par le procédé objet de cette invention, permet une adhérence parfaite de ce film quelles que soient la nature et la structure de la surface du matériau diélectrique utilisé qui peut être un cristal, un aggloméré polycristallin, une poudre ou un verre.

Ces avantages résultent de la formation de centres catalytiquement actifs en très grande concentration à, et au voisinage immédiat de la surface du matériau diélectrique lorsque cette surface est irradiée par un faisceau laser possédant des caractéristiques définies. La formation de ces centres est entièrement contrôlée par les caractéristiques du faisceau laser, d'une part, et la composition du matériau diélectrique. Elle ne dépend pas de la structure superficielle de ce matériau.

L'invention est décrite plus en détail de la façon suivante :

1ère étape : La surface du matériau diélectrique qui doit être métallisée est irradiée par un faisceau laser, préalablement mis en forme (longueur d'onde, énergie, densité d'énergie, temps d'irradiation);

2ème étape : La pièce est plongée dans un bain autocatalytique.

La première étape permet de produire les centres actifs sur la surface irradiée du matériau diélectriau. Celui-ci doit,s uivant l'invention, posséder dans sa structure chimique des atomes métalliques (par exemple, Al$_2$O$_3$, ferrites). Ava,t irradiation, ceux-ci sont naturellement présents à la surface du matériau avec la concentration maximum permise par la structure chimique du matériau, c'est-à-dire que la distance moyenne la plus petite entre atomes métalliques, de la surface non-irradiée du matériau (qui sont couplés à d'autres atomes non-métalliques) est comprise entre 5 et 10 Å. Lors de l'irradiation et en fonction des caractéristiques du faisceau laser, certaines des liaisons chimiques associant les atomes métalliques aux autres atomes sont brisés, libérant des atomes non-métalliques en général (par exemple, oxygène). Ce processus se développe lors d'une irradiation réalisée à l'air libre, en atmosphère contrôlée neutre (par exemple, argon) ou dans une enceinte à vide où la pression est maintenue à des valeurs éventuellement très faibles (< 10$^{-9}$ torr, par exemple). L'irradiation peut être répétée autant de fois que nécessaire pour atteindre la concentration la plus élevée possible de ces centres actifs constitués par les atomes métalliques de la surface, partiellement découplés du réseau atomique du matériau diélectrique irradié.

Lors de la deuxième étape, les ions métalliques du bain auto-catalytique en contact avec la surface du matériau diélectrique, se fixent préférentiellement sur les centres actifs produits lors de l'irradiation (première étape). En conséquence, ces centres actifs se matérialisent par des atomes métalliques du matériau diélectrique qui sont liés d'une part, au réseau atomique de ce matériau et, d'autre part, aux atomes métalliques provenant du bain autocatalytique. Ceci résulte en un contact très intime (par la forte concentration des centres actifs) et très fort (par la nature des liaisons chimiques liant les atomes de part et d'autre de l'interface), entre le matériau diélectrique, d'une part, et le film métallique dont l'épaisseur croît avec le temps d'immersion dans le bain auto-catalytique. L'adhérence du film métallique sur le matériau diélectrique obtenue par le procédé de la présente invention est très élevée et se trouve être, ainsi très supérieure à celle obtenue par les autres techniques connues de l'art.

En particulier, le procédé décrit dans cette invention contient uniquement deux étapes, au lieu de six étapes dans le procédé utilisant une substance organo-métallique. Comme ce procédé, il permet de réaliser des films de géométrie très fine et précise avec une définition des limites de ce film qui dépend uniquement de l'optique utilisée pour la mise en forme du faisceau laser.

Il permet, par ailleurs, d'obtenir suivant cette géométrie des épaisseurs très variées, comprises entre quelques 100 Å et 1 mm.

Exemple N° 1

Une plaque polycristalline d'alumine (épaisseur = 0.5 mm) est irradiée avec un faisceau laser excimère émettant à une longueur d'onde de 248 nm, avec une densité d'énergie de 10 J/cm$^2$, pendant 30 nsec. Après cent irradiations successives de ce type, la plaque d'alumine est plongée dans un bian autocatalytique contenant des ions de cuivre, de composition connue de l'art et maintenu à température ambiante. Après 20 minutes d'immersion, une couche de cuivre d'épaisseur comprise entre 1 et 2 μm est formée uniquement sur les zones de la surface de la plaque d'alumine qui ont été préalablement irradiées. Cette couche de cuivre est très adhérente. Sa conductivité électrique est caractéristique du cuivre polycristallin massif.

Exemple N° 2

Suivant les mêmes conditions d'irradiation que celles décrites dans l'exemple N° 1, une plaque d'alumine est irradiée puis immergée dans un bain catalytique connu de l'art, contenant des ions de nickel, et maintenu à 90°C. Après 10 minutes d'immersion, une couche de nickel de 2 à 3 μm d'épaisseur est obtenue uniquement sur les zones préalablement irradiées. La couche de nickel a toutes les propriétés physico-chimiques du nickel massif.

Exemple N° 3

Suivant les mêmes conditions d'irradiation que celles décrites dans l'exemple n° 1, une pièce en ferrite est irradiée puis immergée dans un bain autocatalytique connu de l'art, contenant des ions de cuivre et maintenu à température ambiante. Après immersion pendant 15 minutes, une couche de cuivre de 1 $\mu$m d'épaisseur est obtenue sans dépôt métallique sur les surfaces non-irradiées qui conservent toutes leurs propriétés physico-chimiques.

Exemple N° 4

Une plaque monocrystalline de sapphire est irradiée avec un faisceau laser excimère émettant à 248 nm avec une densité d'énergie de 10 J/cm², pendant 30 nsec. Après 500 irradiations de ce type, la plaque de sapphire est immergée dans un bain autocatalytique contenant des ions de cuivre. Après 20 minutes d'immersion, un film de cuivre d'épaisseur comprise entre 1 et 2 $\mu$m est obtenu sur la zone irradiée de la plaque. Le procédé n'affecte pas les parties non-irradiées de la plaque de sapphire.

**Revendications**

1. Procédé de métallisation des surfaces de matériaux diélectriques dont la structure chimique contient des atomes métalliques, procédé suivant lequel la métallisation est réalisée en deux étapes successives dont la première consiste à irradier par un faisceau laser, la surface du matériau maintenu à l'air libre ou dans un milieu chimiquement neutre, et dont la seconde consiste à immerger la pièce irradiée dans un bain autocatalytique provoquant le recouvrement des zones préalablement irradiées par une couche du métal contenu dans le bain autocatalytique.

2. Procédé de métallisation tel que décrit dans la revendication 1 en ce que ce procédé est applicable à tous les matériaux diélectriques contenant des atomes métalliques chimiquement intégrés dans la structure du matériau,et ces matériaux comprenant des oxides métalliques monocristallins ($Al_2O_3$, ZrO) ; des oxides métalliques polycristallins (alumine, ZrO, BeO) ; des céramiques contenant des oxides métalliques polycristallins ; des ferrites ; des céramiques supraconductrices ; des composites contenant des oxides métalliques polycristallins ou d'autres composés métalliques ; des composés métalliques (nitrures, borures, carbures) ; des minéraux.

3. Procédé tel que décrit dans les revendications 1 et 2, en ce que la densité de puissance du faisceau laser est suffisante pour libérer partiellement des atomes métalliques qui restent chimiquement fixés à la surface du matériau diélectrique et tel que le faisceau laser peut être émis par un laser excimère travaillant à toute longueur d'onde, un laser à gaz d'azote, un laser YAG travaillant à sa longueur d'onde nominale de 1,06 $\mu$m ou une de ses harmoniques un laser à colorant, un laser à vapeur métallique ou un laser à gaz $CO_2$.

4. Procédé tel que décrit dans les revendications 1, 2 et 3, en ce que le bain autocatalytique utilisé a composition connue de l'art et contient un ou plusieurs des métaux ou alliages suivants : Ni, Cu, Ni-Co, Ni-Cu, Ni-Fe, Ni-Co-Re, Ni-W, Co-W, Ni-Co-W, Co-Zn, Co-Fe, Co-Re, Co-Cu, Co-Mo, Co-Mn, Ag, Au, Pd, Pt, Sn, Cr, Cd, Fe, Pb.

5. Procédé tel que décrit dans les revendications 1 à 4 en ce qu'il est applicable à différentes géométries de la pièce à métalliser et ces géométries comprenant des plaques métallisées sur toutes leurs faces, des conduits cylindriques métallisés sur leurs surfaces interne et externe, la surface de trous aveugles produits préalablement dans ces plaques ou des trous traversant totalement ces plaques et produits préalablement à l'irradiation par des méthodes connues de l'art.

6. Procédé tel que décrit dans les revendications 1 à 4 en ce qu'il est applicable à la métallisation de structures, telles que sillons, trous aveugles et trous produits lors de l'irradiation par le faisceau laser.

7. Procédé tel que décrit dans les revendications 1 à 6 en ce qu'il est applicable à la métallisation de la surface d'un matériau diélectrique telle que limitée à la géométrie de la section du faisceau laser à l'impact sur la surface.

8. Procédé tel que décrit dans les revendications 1 à 7 en ce qu'il est applicable à un matériau diélectrique préparé sous forme d'une poudre, d'un bloc polycristallin, d'un film polycristallin d'un monocristal, d'un verre ou une de ces formes intégrée dans un matériau composite contenant d'autres composants.

**Office européen des brevets**

# RAPPORT DE RECHERCHE EUROPEENNE

Numero de la demande

EP    91 87 0220

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5 ) |
|---|---|---|---|
| X | WORLD PATENTS INDEX LATEST<br>Week 4387, 1987<br>Derwent Publications Ltd., London, GB;<br>AN 87-302800-43<br>& JP-A-62 212 285 (TOSHIBA KK) 18 Septembre 1987<br>* abrégé * <br>--- | 1,2,3,4,<br>5,6,7 | C23C18/18<br>C23C18/16 |
| X | WORLD PATENTS INDEX LATEST<br>Week 8821, 1988<br>Derwent Publications Ltd., London, GB;<br>AN 88-143672-21<br>& JP-A-63 085 078 (TOSHIBA KK) 15 Avril 1988<br>* abrégé * <br>--- | 1,2,3,4,<br>5,6,7 | |
| A | PATENT ABSTRACTS OF JAPAN<br>vol. 12, no. 82 (C-481)(2929) 15 Mars 1988<br>& JP-A-62 218 580 ( TOSHIBA CORP ) 25 Septembre 1987<br>* abrégé * | | |

-----

**DOMAINES TECHNIQUES RECHERCHES (Int. Cl.5 )**

C23C

Le présent rapport a été établi pour toutes les revendications

| Lieu de la recherche | Date d'achèvement de la recherche | Examinateur |
|---|---|---|
| LA HAYE | 26 JUIN 1992 | NGUYEN THE NGHIEP N. |

EPO FORM 1503 03.82 (P0402)